Europäisches Patentamt

European Patent Office

Office européen des brevets

(19)

(11) Veröffentlichungsnummer : **0 035 767**
**B1**

(12) ## EUROPÄISCHE PATENTSCHRIFT

(45) Veröffentlichungstag der Patentschrift :
18.06.86

(51) Int. Cl.⁴ : **H 01 L 23/56**

(21) Anmeldenummer : 81101619.5

(22) Anmeldetag : 06.03.81

(54) **Halbleiteranordnung.**

(30) Priorität : 11.03.80 DE 3009192

(43) Veröffentlichungstag der Anmeldung :
16.09.81 Patentblatt 81/37

(45) Bekanntmachung des Hinweises auf die Patenterteilung : 18.06.86 Patentblatt 86/25

(84) Benannte Vertragsstaaten :
CH FR GB IT LI

(56) Entgegenhaltungen :
DE-A- 1 514 368
DE-A- 2 130 900
DE-A- 2 740 539
DE-A- 2 834 866

(73) Patentinhaber : SEMIKRON, GESELLSCHAFT FÜR GLEICHRICHTERBAU UND ELEKTRONIK M.B.H.
Sigmundstrasse 200
D-8500 Nürnberg 82 (DE)

(72) Erfinder : Tursky, Werner, Dr. Dipl.-Ing.
Aldringerstrasse 15
D-8500 Nürnberg (DE)
Erfinder : Fuchs, Hans-Jürgen, Dipl.-Ing.
Goethering 54
D-8504 Stein (DE)
Erfinder : Grube, Reinhard, Dr. Dipl.-Phys.
Tuchergartenstrasse 29
D-8500 Nürnberg (DE)

EP 0 035 767 B1

## Beschreibung

Die Erfindung betrifft eine Halbleiteranordnung nach dem Oberbegriff des Anspruchs 1.

Um eine unzulässige Überlastung von Halbleiterbauelementen hoher Strombelastbarkeit im Betrieb zu vermeiden, müssen die Betriebskenngrößen, insbesondere der Laststrom und die Temperatur, überwacht werden. Beispielsweise werden als thermische Sensoren Bimetallschalter (vergl. US-PS 3 515 645) oder PTC-Widerstände oder NTC-Widerstände (vergl. US PS 3 026 469) verwendet, die am Halbleiterbauelement befestigt sind und bei Erreichen einer maximal zulässigen Betriebstemperatur des letzteren dessen Abschaltung bewirken. Derartige Schutzelemente können jedoch nicht unmittelbar am Halbleiterkörper der Bauelemente angebracht werden. Infolge der zwischen dem Halbleiterkörper und dem Schutzelement vorhandenen Wärmewiderstände entsteht eine Ansprechverzögerung, welche häufig einen wirksamen Schutz der Halbleiterbauelemente durch solche thermischen Sensoren verhindert.

Bekannt ist weiterhin auch die Verwendung von speziellen Halbleitersensoren. Ihr Einsatz bringt jedoch zusätzliche Spannungs- und Wärmeverluste mit sich und erfordert einen teilweise bedeutenden zusätzlichen Platzbedarf.

Bei entsprechenden Überlastfällen werden die relativ teueren Sicherungselemente dennoch zerstört, und schließlich sind dieselben nicht in allen Fällen zuverlässig.

In der DE-A 2 834 866 ist eine als Emitter-Detektor-Strahlungsbaugruppe bezeichnete Kombination zweier Halbleiterbauelemente beschrieben. Die für den Einsatz von elektro-lumineszenten Bauelementen gewünschte Linearisierung des Ausgangssignals soll durch Überwachung bzw. Nutzung der Sekundär-Emission solcher Bauelemente in der Weise erzielt werden, daß das gemessene elektrische Signal der Sekundär-Emission in einen Rückkopplungskreis eingespeist wird, der einen das elektro-lumineszente Bauelement versorgenden Schaltkreis steuert. Dazu sind das elektro-lumineszente Bauelement und ein Strahlungsdetektor über einen gemeinsamen Halter, der gleichzeitig ihre galvanische Verbindung bildet, geeignet auf einer Grundplatte befestigt.

Der Erfindung lag die Aufgabe zugrunde, eine Überwachungseinrichtung für Halbleiterbauelemente anzugeben, welche eine in jedem Fall sichere und möglichst schnell ansprechende Kontrolle des elektrischen bzw. thermischen Betriebsverhaltens von Halbleiterbauelementen ermöglicht. Die Erfindung geht von der Erkenntnis aus, daß beim Stromfluß durch einen Halbleiterkörper in diesem eine sogenannte Rekombinationsstrahlung entsteht, daß es sich bei dieser Strahlung um eine Infrarotstrahlung handelt, und daß diese Infrarotstrahlung dem Stromfluß proportional ist.

Die Lösung dieser Aufgabe besteht bei einer Halbleiteranordnung der eingangs erwähnten Art in den Merkmalen des kennzeichnenden Teils des Anspruchs 1.

Das Kontrollelement ist gleichzeitig zur Überwachung des Laststroms und der Temperatur des Halbleiterbauelements vorgesehen.

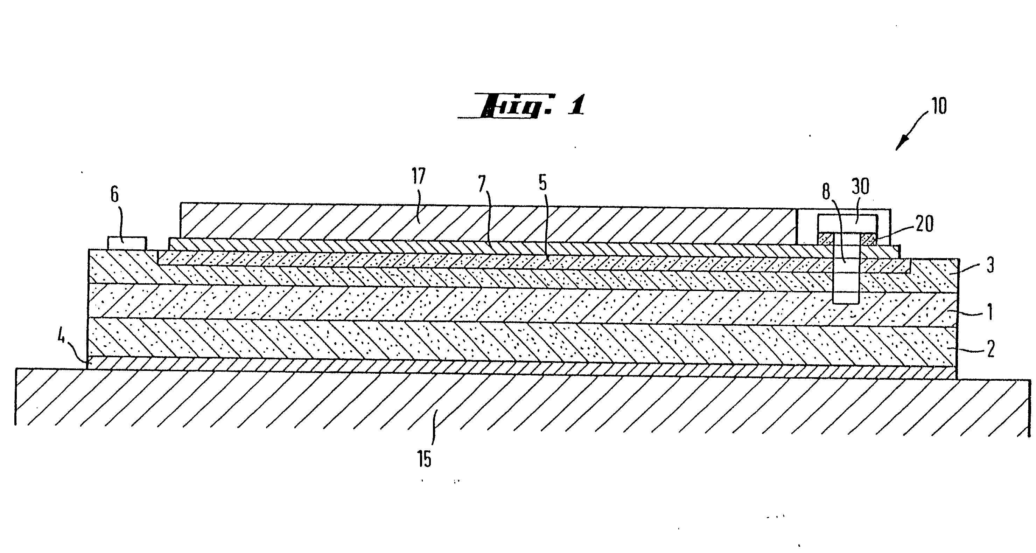

Es können Kontrollelemente auf Halbleiterbasis sowohl mit wenigstens einem pn-Übergang und zur Temperaturüberwachung mit Hilfe ihres Durchlaßverhaltens oder mit Hilfe ihres Dunkelstromverhaltens, oder aber Kontrollelemente auf Halbleiterbasis ohne pn-Übergang und zur Temperaturüberwachung mit Hilfe ihrer Dunkelwiderstandsänderung, jeweils in der Sperrphase des Halbleiterbauelements, vorgesehen sein. Anhand der in den Figuren 1-4 dargestellten Ausführungsbeispiele wird der Gegenstand der Erfindung aufgezeigt und erläutert.

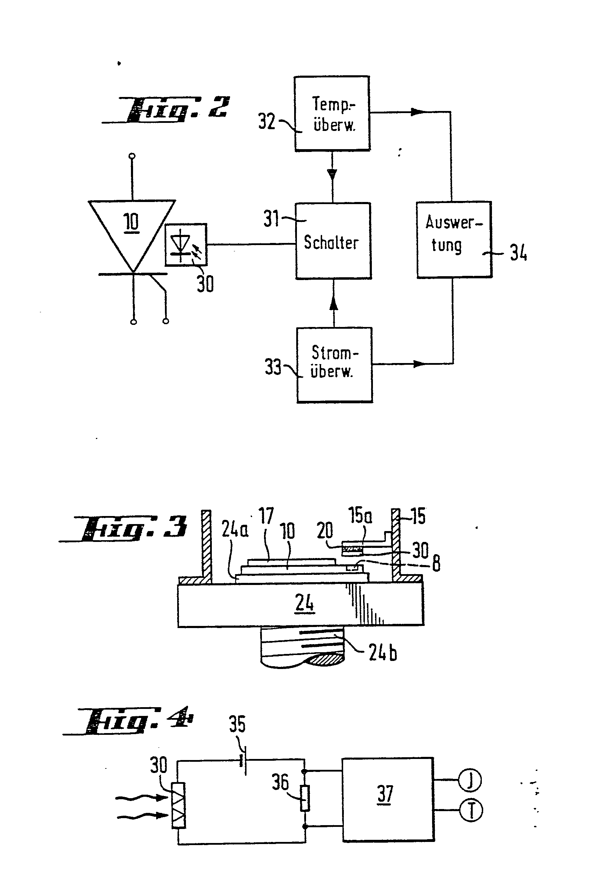

Figur 1 zeigt im Querschnitt den Halbleiterkörper eines zu überwachenden Thyristors mit einem unmittelbar daran befestigten Kontrollelement. In Figur 2 ist schematisch die Halbleiteranordnung nach der Erfindung und eine zur Auswertung der Funktion des Kontrollelements geeignete Schaltungsanordnung dargestellt. Figur 3 zeigt teilweise im Querschnitt und teilweise in Seitenansicht den Aufbau eines Halbleiterbauelements mit Teilen seines Gehäuses und mit einem thermisch am Gehäuse befestigten Kontrollelement. In Figur 4 ist schematisch ein mit einer Überwachungsschaltung verbundener Photowiderstand gezeigt, der in entsprechender Weise an einem Halbleiterbauelement zu befestigen ist.

Gleiche Teile sind in allen Figuren mit gleichen Bezeichnungen versehen.

Der eine Thyristorstruktur bildende Halbleiterkörper 10 nach Figur 1 besteht aus einer hochohmigen, n-leitenden Mittelzone 1, aus je einer an jeder Seite derselben angrenzenden, höherdotierten p-leitenden Zone 2 bzw. 3, aus einer in die obere Zone eingebrachten, hochdotierten, n-leitenden Zone 5, sowie aus auf die äußeren Zonen 2 bzw. 5 aufgebrachten Kontaktelektroden 4 bzw. 7 für den Laststromanschluß und aus einer auf die p-leitende Zone 3 aufgebrachten Steuerelektrode 6 für den Steueranschluß. Dieser Schichtenaufbau ist zwischen Leiterteilen 15 bzw. 17 fest angeordnet.

Der Halbleiterkörper 10 weist eine von einer Oberfläche, beispielsweise von der Kontaktelektrode 7, sich bis in die p-leitende Zone 3 erstreckende Öffnung 8 auf, die als Strahlungsfenster für die im Halbleiterkörper bei Stromfluß entstehende Rekombinationsstrahlung dient. Wegen der Neigung von hochdotiertem Halbleitermaterial zur Absorption der Rekombinationsstrahlung genügt es nicht, lediglich die Halbleiteroberfläche zur Herstellung einer Strahlungsfläche freizulegen, sondern es ist eine Öffnung mit einer Tiefe bis in eine der höherohmigen Zonen erforderlich. Der Querschnitt der Öffnung 8 ist der Belichtungsfläche des vorgesehenen Kontrollelements angepaßt. Die Lage der Öffnung 8 ist im wesentlichen beliebig. Aus technologischen Gründen befindet sie sich jedoch vorzugsweise am Rande der durch die Kontaktelektrode 7 bestimmten Fläche, beispielsweise in einer Aussparung des Stromleiters 17. Grundsätzlich muß die Rekombinationsstrahlung aus dem Halbleitermaterial austreten und auf die zu belichtende Fläche des Kontrollelements auftreffen. Demzufolge ist auch das Kontrollelement mit dem für die Belichtung vorgesehenen Flächenabschnitt in entsprechender Weise auf dem Halbleiterkörper angebracht.

Gemäß der Darstellung in Figur 1 ist das Kontrollelement über eine elektrisch isolierende Schicht 20 auf dem entsprechend vorbereiteten Oberflächenabschnitt des Halbleiterkörpers 10 befestigt. Die Befestigung sowohl des Isolierstoffkörpers 20 als auch des Kontrollelements 30 kann beispielsweise durch Kleben oder auch durch Löten erfolgen. Als Isolierstoffkörper kann z. B. eine angepaßt ringförmige Scheibe aus Oxidkeramik dienen, die an ihren Flächen mit den angrenzenden Bauteilen verbunden ist und in ihrem zentralen Bereich eine Aussparung aufweist zum Durchtritt der Strahlung auf die zu belichtende Fläche des Überwachungselements.

Als Isolierstoffkörper 20 kann jedoch auch eine Scheibe aus Quarz vorgesehen sein, da Quarz für die Rekombinationsstrahlung uneingeschränkt durchlässig ist.

Eine andere Möglichkeit besteht darin, für die Anordnung des Kontrollelements 30 eine entsprechende Fassung vorzusehen, die auf dem Isolierstoffkörper 20 in gewünschter Weise befestigt werden kann, und in welcher das Kontrollelement gehalten ist.

Die gesamte freiliegende Fläche der Öffnung 8 kann mit einer Schicht aus dem Oxid des Halbleitermaterials als schützendem Überzug versehen sein.

Die Herstellung der Öffnung 8 kann durch Ätzen oder durch andere bekannte abtragende Verfahren erfolgen. Das Kontrollelement 30 ist wie beschrieben thermisch mit dem Halbleiterkörper 10 gekoppelt. Das gestattet optimal sowohl die Stromüberwachung im Halbleiterbauelement als auch die Überwachung der Betriebstemperatur desselben, die beispielsweise durch Ausfall der Kühlung des Halbleiterbauelements oder aber durch Verschlechterung eines Wärmeübergangs im Aufbau desselben in unerwünschter Weise zunehmen kann.

Es sind Kontrollelemente auf Halbleiterbasis ohne pn-Übergang, d. h. sogenannte Photowiderstände, und solche auf Halbleiterbasis mit wenigstens einem pn-Übergang, d. h. Photodioden und Phototransistoren vorgesehen.

Wie bereits oben ausgeführt, ist die Rekombinationsstrahlung im Halbleiterkörper dem Stromfluß durch denselben in weiten Bereichen proportional. Von dieser Tatsache, sowie davon, daß bei Kontrollelementen mit pn-Übergang das Durchlaßverhalten derselben sowie ihr Dunkelstrom und bei Photowiderständen deren Dunkelwiderstand jeweils zur Betriebstemperatur des Kontrollelements und damit auch des zu überwachenden Halbleiterbauelements in Beziehung gesetzt werden kann, macht die Erfindung in vorteilhafterweise Gebrauch. Dadurch ist überraschend einfach eine im wesentlichen leitstungs- und trägheitslose sowie phasentreue Überwachung von Kenngrößen bei Halbleiterbauelementen erzielbar.

Aus Figur 2 ist zu erkennen, daß beispielsweise eine Photodiode 30 über einen Schalter 31 einerseits mit einem Meßkreis 32 zur Feststellung des Durchlaßspannungsabfalls der Photodiode und andererseits mit einem Meßkreis 33 zur Messung des Photostromes verbunden ist. Dabei ist der Schalter vorzugsweise mit Hilfe eines netzsynchronen Taktgenerators im Takt der Netzfrequenzhalbwellen umschaltbar. Einmal wird durch einen Stromgenerator im Meßkreis 32 der Photodiode 30 ein konstanter Durchlaßstrom der letzteren eingeprägt, und in Abhängigkeit von der thermischen Kopplung der Photodiode an das zu schützende Bauelement wird der Durchlaßspannungsabfall der Photodiode festgestellt. Dieser verändert sich umgekehrt proportional zur Umgebungstemperatur, so daß ein direkter Vergleich der gemessenen Werte mit der zu überwächenden Betriebstemperatur möglich ist.

Zum anderen wird die Photodiode 30 mit Hilfe einer Spannungsquelle im Meßkreis 33 in Sperrichtung beaufschlagt, und der Photostrom stellt sich als Funktion der Beleuchtungsstärke auf der belichteten Fläche des Kontrollelementes dar. Die Schaltkreise als solche sowie die Maßnahmen zur Messung von elektrischen Größen des Kontrollelementes 30 und bedarfsweise zur Verstärkung derselben sind hinlänglich bekannt und nicht Gegenstand der Erfindung.

Nachdem der Dunkelstrom ebenfalls als Funktion der Umgebungstemperatur darstellbar ist, ist es möglich, im Hinblick auf die Verwendbarkeit der vorgesehenen Kontrollelemente auch bei hohen Frequenzen die Temperaturüberwachung mit Hilfe des Dunkelstromes vorzunehmen. Im Zusammenhang mit der Ermittlung von Meßwerten kann beispielsweise auch eine geeignete Fehlermeldung mit verbunden sein, ferner kann für den Zündkreis des zu überwachenden Bauelements, wenn es sich um einen Thyristor handelt, auch ein Signal für eine Zündsperre erfolgen.

Die Auswertung der Meßergebnisse ist somit in an sich bekannter und aus der Elektronik bekannter Weise durchführbar.

Die in Figur 2 dargestellte Blockschaltung ist nicht auf die Verbindung mit nur einem Kontrollelement beschränkt. Vielmehr lassen sich beispielsweise für eine Halbleitergleichrichterschaltung mit sechs Gleichrichterbauelementen sämtliche sechs Kontrollelemente mit der einen dargestellten Überwachungsschaltung verbinden. In Figur 3 ist eine andere Möglichkeit für die Anbringung eines Kontrollelements dargestellt. Ein vorzugsweise aus Kupfer bestehender Trägerkörper 24, der gleichzeitig als Stromleiter und als Gehäuseunterteil mit einem Schraubstutzen 24b dient, weist an seiner oberen Fläche einen Ansatz 24a zur Anbringung des Halbleiterkörpers 10 auf. Der letztere ist mit einer Öffnung 8 versehen. An der Innenfläche des nur teilweise dargestellten Gehäuseoberteiles 15 ist das Kontrollelement 30 über einen Isolierstoffkörper 20 an einer Haltevorrichtung 15a so angebracht, daß die aus der Öffnung 8 des Halbleiterkörpers 10 austretende Rekombinationsstrahlung die zu belichtende Fläche jedes Kontrollelements trifft. Es verstehtsich, daß der Zusammenbau einer solchen Anordnung besondere Kennzeichnungen der Gehäuseteile zu deren Lage bestimmter gegenseitiger räumlicher Zuordnung zur Sicherstellung der Funktionsfähigkeit des Kontrollelements erfordert.

Die Halterung 15a besteht vorzugsweise aus einem gut wärmeleitenden Metall zur optimalen thermischen Ankopplung des Kontrollelements an das Gehäuse 15 und ist so angebracht, daß ein möglichst geringer Abstand des Kontrollelements zum Halbleiterkörper 10 besteht.

Eine solche thermische Kopplung bringt wohl gegenüber der unmittelbaren Verbindung mit dem Halbleiterkörper wegen des längeren Weges der Verlustwärme zum Kontrollelement eine gewisse Trägheit der Überwachungsfunktion mit sich, erscheint jedoch besonders vorteilhaft zur Überwachung der Wärmewiderstände im Aufbau des zu überwachenden Bauelements bzw. der Funktion der Kühleinrichtung. Selbstverständlich kann die Befestigung des Kontrollelementes 30 auch an geeigneter Stelle des Grundkörpers 24 erfolgen.

Die Anschlußleitungen des Kontrollelements können beispielsweise mit Hilfe eines Keramikrohres duch das Gehäuse oben eingeführt sein.

Nach der Darstellung in Figur 4 ist ein Photowiderstand 30 einer lediglich durch Pfeile symbolisiert angedeuteten Strahlung des Halbleiterkörpers ausgesetzt. Entsprechend dem Zusammenhang zwischen Photostrom und Beleuchtungsstärke z. B. bei einer Photodiode ist der sogenannte helle Widerstand des Kontrollelements 30 eine Funktion der Beleuchtungsstärke.

In dem Basiskreis ist dem Photowiderstand 30 aus einer Batterie 35 eine Basisspannung eingeprägt. Der durch Bestrahlung erzeugte Photostrom im Photowiderstand erzeugt eine Widerstandsänderung, die mit Hilfe des Spannungsabfalls an den Meßwiderstand 36 und der zu diesem parallel geschalteten nicht erfindungswesentlichen Schaltung 37 ausgewertet wird. Im wesentlichen mit derselben Grundschaltung kann auch der Dunkelwiderstand des Kontrollelements 30 als Funktion der Betriebstemperatur des letzteren und des zum Halbleiterbauelementes zu dessen Überwachung dienen.

Bei der Herstellung eines Aufbaus gemäß Figur 3 werden in an sich bekannter Weise zunächst auf dem vorbehandelten Trägerkörper 24 der Halbleiterkörper 10 und auf diesem der obere Anschlußleiter angebracht, wovon mit dem Bauteil 17 nur ein Teil desselben angedeutet ist.

Die das Kontrollelement 30 tragende Haltevorrichtung 15a kann mit dem Gehäuseoberteil 15 beispielsweise durch Löten oder Schweißen oder mit Hilfe eines Metallklebers fest verbunden sein. Mit Hilfe einer geeigneten Markierung wird anschließend das Gehäuseoberteil 15 auf dem Trägerkörper 24 befestigt.

Der Vorteil des Gegenstandes der Erfindung besteht in einer im wesentlichen leistungs- und trägheitslosen sowie phasentreuen und frequenzunabhängigen Überwachung von Kenngrößen bei Kalbleiterbauelementen durch Anwendung bekannter Bauelemente mit photoelektrischem Effekt.

## Patentansprüche

1. Halbleiteranordnung, die wenigstens ein Halbleiterbauelement und ein dessen Funktion überwachendes Kontrollelement (30) aufweist, und bei welcher als Kontrollelement (30) ein Bauelement mit innerem photoelektrischen Effekt zur Aufnahme der beim Stromdurchgang durch das Halbleiterbauelement in dessen Halbleiterkörper (10) entstehenden Rekombinationsstrahlung vorgesehen ist, dadurch gekennzeichnet, daß in der einen Oberfläche des Halbleiterkörpers (10) eine Strahlaustrittsöffnung (8) angebracht ist, die sich bis in eine der höherohmigen Zonen(1) erstreckt, und daß das Kontrollelement (30) thermisch mit dem Halbleiterkörper (10) gekoppelt ist.

2. Halbleiteranordnung nach Anspruch 1, dadurch gekennzeichnet, daß ein Kontrollelement (30) auf Halbleiterbasis mit wenigstens einem pn-Übergang und zur Temperaturüberwachung mit Hilfe seines Durchlassverhaltens in der Sperrphase des Halbleiterbauelements vorgesehen ist.

3. Halbleiteranordnung nach Anspruch 1, dadurch gekennzeichnet, daß ein Kontrollelement (30) auf Halbleiterbasis mit wenigstens einem pn-Übergang und zur Temperaturüberwachung mit Hilfe seines Dunkelstromverhaltens in der Sperrphase des Halbleiterbauelements vorgesehen ist.

4. Halbleiteranordnung nach Anspruch 1, dadurch gekennzeichnet, daß ein Kontrollelement (30) auf Halbleiterbasis ohne pn-Übergang und zur Temperaturüberwachung mit Hilfe seiner Dunkelwiderstandsänderung in der Sperrphase des Halbleiterbauelements vorgesehen ist.

5. Halbleiteranordnung nach Anspruch 1, dadurch gekennzeichnet, daß das Kontrollelement (30) über eine elektrisch isolierende Schicht (20) mit dem Halbleiterkörper (10) verbunden ist.

6. Halbleiteranordnung nach Anspruch 1, dadurch gekennzeichnet, daß das Kontrollelement (30) an einem Gehäuseteil (15) des Halbleiterbauelements befestigt ist.

7. Verwendung einer Halbleiteranordnung nach einem der Ansprüche 1 bis 6 zur Strom- und Temperaturüberwachung des Halbleiterbauelements.

## Claims

1. Semiconductor device comprising at least one semiconductor component and a monitoring element (30) monitoring the function thereof, and in which as monitoring element (30) a component with internal photoelectric effect is provided for receiving the recombination radiation arising on passage of current through the semiconductor component in the semiconductor body (10) thereof, characterized in that in the one surface of the semiconductor body (10) a beam exit opening (8) is formed which extends into the higher resistance zones (1) and that the monitoring element (30) is thermally coupled to the semiconductor body (10).

2. Semiconductor device according to claim 1, characterized in that a monitoring element (30) on semiconductor basis is provided having at least one pn junction and for temperature monitoring with the aid of its passage behaviour in the blocking phase of the semiconductor component.

3. Semiconductor device according to claim 1, characterized in that a monitoring element (30) is provided on semiconductor basis having at least one pn junction and for temperature monitoring with the aid of its dark-current behaviour in the blocking phase of the semiconductor component.

4. Semiconductor device according to claim 1, characterized in that a monitoring element (30) is provided on semiconductor basis without pn junction and for temperature monitoring with the aid of its dark resistance change in the blocking phase of the semiconductor component.

5. Semiconductor device according to claim 1, characterized in that the monitoring element (30) is connected via an electrically insulating layer (20) to the semiconductor body (10).

6. Semiconductor device according to claim 1, characterized in that the monitoring element (30) is secured to a housing portion (15) of the semiconductor component.

7. Use of a semiconductor device according to any one of claims 1 to 6 for current and temperature monitoring of the semiconductor component.

**Revendications**

1. Dispositif semi-conducteur comportant au moins un élément constitutif semi-conducteur et un élément de contrôle (30) de surveillance du fonctionnement dudit élément semi-conducteur, constitué d'un élément présentant un effet photoélectrique interne en vue de la réception du rayonnement de recombinaison se produisant lors de la pénétration du courant à travers l'élément semi-conducteur dans le corps semi-conducteur (10) de celui-ci, caractérisé par une ouverture (8) de sortie du rayonnement, prévue dans l'une des surfaces du corps semi-conducteur et s'étendant jusque dans une zone de valeur ohmique supérieure, et, par un couplage thermique entre l'élément de contrôle (30) et le corps semi-conducteur (10).

2. Dispositif semi-conducteur selon la revendication 1 caractérisé par un élément de contrôle (30) prévu sur une base semi-conductrice avec au moins une jonction pn, dans la phase diélectrique de l'élément semi-conducteur, en vue de la surveillance de la température à partir de ses caractéristiques à l'état passant.

3. Dispositif semi-conducteur selon la revendication 1 caractérisé par un élément de contrôle (30) prévu sur une base semi-conductrice avec au moins une jonction pn, dans la phase diélectrique de l'élément semi-conducteur, en vue de la surveillance de la température à partir des caractéristiques de son courant d'obscurité.

4. Dispositif semi-conducteur selon la revendication 1 caractérisé par un élément de contrôle (30) prévu sur une base semi-conductrice sans jonction pn, dans la phase diélectrique de l'élément semi-conducteur, en vue de la surveillance de la température grâce à la modification de sa résistance d'obscurité.

5. Dispositif semi-conducteur selon la revendication 1 caractérisé en ce que l'élément de contrôle (30) est relié au corps semi-conducteur (10) par une couche isolante (20).

6. Dispositif semi-conducteur selon la revendication 1 caractérisé en ce que l'élément de contrôle (30) est fixé sur une partie du boîtier (15) de l'élément constitutif semi-conducteur.

7. Application d'un dispositif semi-conducteur selon l'une des revendications 1 à 6 en vue de la surveillance du courant et de la température de l'élément constitutif semi-conducteur.

**Fig. 1**

1

*Fig. 2*

*Fig. 3*

*Fig. 4*